# EUROPEAN PATENT APPLICATION

(11) **EP 4 629 221 A1**
(43) Date of publication of application: **08.10.2025**
(21) Application number: 25168068.2
(22) Date of filing: 02.04.2025
(51) Int. Cl.: G09G 3/00, H10K 59/131, H10K 59/80, H10K 71/70

(54) **DISPLAY DEVICE AND ELECTRONIC DEVICE INCLUDING THE SAME**

(30) Priority: 03.04.2024 KR 20240045365
(71) Applicant: Samsung Display Co., Ltd., Yongin-si, Gyeonggi-do 17113 (KR)
(72) Inventor: LEE, Chang-Yeol, 17113 Yongin-si (KR); KIM, Jaewon, 17113 Yongin-si (KR); MOON, Joong-Soo, 17113 Yongin-si (KR); CHO, Youngjin, 17113 Yongin-si (KR); KIM, Hansol, 17113 Yongin-si (KR)
(74) Representative: Taor, Simon Edward William

(57) **Abstract**

A display device includes: a substrate having a display area and a non-display area adjacent to the display area; a plurality of pixels on the substrate, and each of which comprises a transistor and a light emitting element connected to the transistor; an encapsulating layer covering the pixels and having an end defined in the non-display area; a crack detecting circuit in the non-display area along at least a portion of an edge of the display area, and comprising one end and the other end; and an antistatic circuit in the non-display area and connected to the crack detecting circuit, wherein the antistatic circuit is spaced apart from the end of the encapsulating layer in a plan view.

## Description

### BACKGROUND

Aspects of some embodiments of the present disclosure relate to a display device.

In general, electronic apparatuses such as smartphones, digital cameras, notebook computers, navigation units and smart televisions, which display images for users, include display devices for displaying the images. The display devices generate images and provide the generated images for users through display screens.

The display devices each include a plurality of pixels for generating an image, and a plurality of lines connected to the pixels. The pixels are driven by receiving driving signals through the lines.

The above information disclosed in this Background section is only for enhancement of understanding of the background and therefore the information discussed in this Background section does not necessarily constitute prior art.

### SUMMARY

Aspects of some embodiments of the present disclosure include a display device with relatively improved reliability.

According to some embodiments of the present disclosure, a display device includes a substrate in which a display area and a non-display area adjacent to the display area are defined, a plurality of pixels, which are on the substrate and each of which includes a transistor and a light emitting element connected to the transistor, an encapsulating layer which covers the pixels and has an end defined in the non-display area, a crack detecting circuit in the non-display area along at least a portion of an edge of the display area and includes one end and the other end, and an antistatic circuit in the non-display area and connected to the crack detecting circuit. According to some embodiments, the antistatic circuit is spaced apart from the end of the encapsulating layer in a plan view.

According to some embodiments, the crack detecting circuit may include a crack detecting line extending along at least three sides of the display area and including one end and the other end, a first pad connected to the one end of the crack detecting line, and a second pad connected to the other end of the crack detecting line. According to some embodiments, the antistatic circuit may be adjacent to the first pad or the second pad.

According to some embodiments, the antistatic circuit may include a first antistatic circuit connected to a portion, which is adjacent to the first pad, of the crack detecting line, and a second antistatic circuit connected to a portion, which is adjacent to the second pad, of the crack detecting line.

According to some embodiments, the display device according to some embodiments of the present disclosure may further include a data driver in the non-display area to be connected to the pixels, and the one end and the other end of the crack detecting line may be spaced apart from each other with the data driver therebetween.

According to some embodiments, the display device according to some embodiments of the present disclosure may further include a data driver in the non-display area to be connected to the pixels, and the one end and the other end of the crack detecting line may be at the same side with respect to the data driver.

According to some embodiments, the antistatic circuit may not overlap the encapsulating layer in a plan view.

According to some embodiments, the antistatic circuit may overlap the first pad or the second pad when viewed in one direction.

According to some embodiments, the antistatic circuit may overlap the encapsulating layer in a plan view.

According to some embodiments, the antistatic circuit may be between the crack detecting line and the display area.

According to some embodiments, the crack detecting line may include at least one bending portion, and the bending portion may be concave or convex toward the display area.

According to some embodiments, the display device may further include an alignment mark in the non-display area, and the bending portion may be concave toward the alignment mark.

According to some embodiments, the crack detecting line may include a first line extending in one direction, and a second line extending in the one direction, on the same layer as the first layer, and overlapping the first layer in at least a partial area in a plan view. According to some embodiments, the first line and the second line may be in contact with each other in the at least a partial area.

According to some embodiments, each of the first line and the second line may include at least one bending portion, and the first line and the second line may entirely overlap each other.

According to some embodiments, the encapsulating layer may include at least one inorganic film and at least one organic film, and the end of the encapsulating layer may be defined by the inorganic film.

According to some embodiments, the encapsulating layer may include a plurality of inorganic films, and the end of the encapsulating layer may be aligned ends of at least two inorganic films.

According to some embodiments of the present disclosure, a display device includes a substrate in which a display area and a non-display area adjacent to the display area are defined, a plurality of pixels, which are on the substrate and each of which includes a transistor and a light emitting element connected to the transistor, an encapsulating layer which covers the pixels and has an end defined in the non-display area, a crack detecting line in the non-display area along at least a portion of an edge of the display area and includes one end and the other end, and an antistatic circuit in the non-display area and connected to the one end or the other end of the crack detecting line. According to some embodiments, the antistatic circuit may not overlap the end of the encapsulating layer in a plan view.

According to some embodiments, the encapsulating layer may include a first inorganic film, a second inorganic film, and an organic film between the first inorganic film and the second inorganic film, and the end of the encapsulating layer may be aligned ends of the first inorganic film and the second inorganic film.

According to some embodiments, the antistatic circuit may overlap the first inorganic film and the second inorganic film in a plan view.

According to some embodiments, the antistatic circuit may not overlap the first inorganic film and the second inorganic film in a plan view.

According to some embodiments, the crack detecting circuit may include at least one bending portion, and the bending portion may have a shape that is concave or convex toward the display area.

According to an aspect, there is provided an electronic device comprising: a display panel; and a window covering the display panel, and the display panel comprising: a substrate having a display area and a non-display area adjacent to the display area; a plurality of pixels on the substrate, and each of which comprises a transistor and a light emitting element connected to the transistor; an encapsulating layer covering the pixels and having an end defined in the non-display area; a crack detecting line in the non-display area along at least a portion of an edge of the display area, and comprising a first end and a second end; and an antistatic circuit in the non-display area and connected to the first end or the second end of the crack detecting line, wherein the antistatic circuit does not overlap the end of the encapsulating layer in a plan view.

According to some embodiments, the encapsulating layer may comprise: a first inorganic film; a second inorganic film; and an organic film between the first inorganic film and the second inorganic film, wherein the end of the encapsulating layer is aligned with ends of the first inorganic film and the second inorganic film.

According to some embodiments, the antistatic circuit overlaps the first inorganic film and the second inorganic film in a plan view.

According to some embodiments, the antistatic circuit does not overlap the first inorganic film and the second inorganic film in a plan view.

According to some embodiments, the encapsulating layer may comprise: a crack detecting circuit comprising the crack detecting line and comprising at least one bending portion, wherein the bending portion has a shape that is concave or convex toward the display area.
According to an aspect, there is provided a display device as set out in claim 1. Additional features are set out in claims 2 to 14. According to an aspect, there is provided an electronic device as set out in claim 15.

### BRIEF DESCRIPTION OF THE DRAWINGS

The accompanying drawings are included to provide a further understanding of the inventive concept, and are incorporated in and constitute a part of this specification. The drawings illustrate embodiments of the inventive concept and, together with the description, serve to explain aspects of some embodiments of the present disclosure. In the drawings:
FIG. 1 is a perspective view of a display device according to some embodiments of the present disclosure;
FIG. 2 is a view illustrating an example of a cross-section of the display device illustrated in FIG. 1;
FIG. 3 is a view illustrating an example of a cross-section of a display panel illustrated in FIG. 2;
FIG. 4 is a block diagram of the display device illustrated in FIG. 1;
FIG. 5 is a view illustrating an example of a cross-section of a display panel corresponding to a partial area of a pixel illustrated in FIG. 4;
FIG. 6 is a plan view of a display panel illustrated in FIG. 1;
FIG. 7 is a view illustrating some components of the display panel illustrated in FIG. 6;
FIG. 8 is an enlarged view illustrating a partial area in FIG. 7;
FIGS. 9A to 9C are schematic cross-sectional views illustrating an area taken along line I-I' in FIG. 8;
FIG. 10A is a circuit diagram of an antistatic circuit according to some embodiments of the present disclosure;
FIG. 10B is a view illustrating a layout of an antistatic circuit according to some embodiments of the present disclosure;
FIGS. 11A to 11C are plan views illustrating a partial area of a crack detecting line according to some embodiments of the present disclosure;
FIG. 12A is a schematic cross-sectional view illustrating the crack detecting line illustrated in FIG. 11B;
FIG. 12B is a schematic cross-sectional view illustrating the crack detecting line illustrated in FIG. 11C;
FIG. 13A is a plan view of a display panel according to some embodiments of the present disclosure;
FIG. 13B is an enlarged view illustrating a partial area in FIG. 13A;
FIG. 14 is a plan view of a display panel according to some embodiments of the present disclosuret;
FIG. 15A is a plan view of a crack detecting line according to a Comparative Example; and
FIG. 15B is a plan view of a crack detecting line according to some embodiments of the present disclosure.

### DETAILED DESCRIPTION

It will be understood that when an element (or region, layer, section, etc.) is referred to as being "on", "connected to" or "coupled to" another element in this specification, it can be directly on, connected or coupled to the other element or a third element may be located between the elements.

Like reference numbers or symbols refer to like elements throughout. In addition, in the drawings, the thickness, the ratio, and the dimension of elements are exaggerated for effective description of the technical contents.

The term "and/or" includes one or more combinations which may be defined by relevant elements.

It will be understood that, although the terms first, second, etc. may be used herein to describe various elements, these elements should not be limited by these terms. These terms are only used to distinguish one element from another element. For example, a first element could be termed a second element without departing from the teachings of the present invention, and similarly, a second element could be termed a first element. As used herein, the singular forms are intended to include the plural forms as well, unless the context clearly indicates otherwise.

In addition, the terms, such as "below", "beneath", "on" and "above", are used for explaining the relation of elements shown in the drawings. These terms are relative concepts, and are explained based on the direction shown in the drawing.

Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

It will be further understood that the terms such as "includes" or "has", when used herein, specify the presence of stated features, numerals, steps, operations, elements, parts, or the combination thereof, but do not preclude the presence or addition of one or more other features, numerals, steps, operations, elements, parts, or the combination thereof.

Hereinafter, aspects of some embodiments of the present disclosure will be described in more detail with reference to the accompanying drawings.

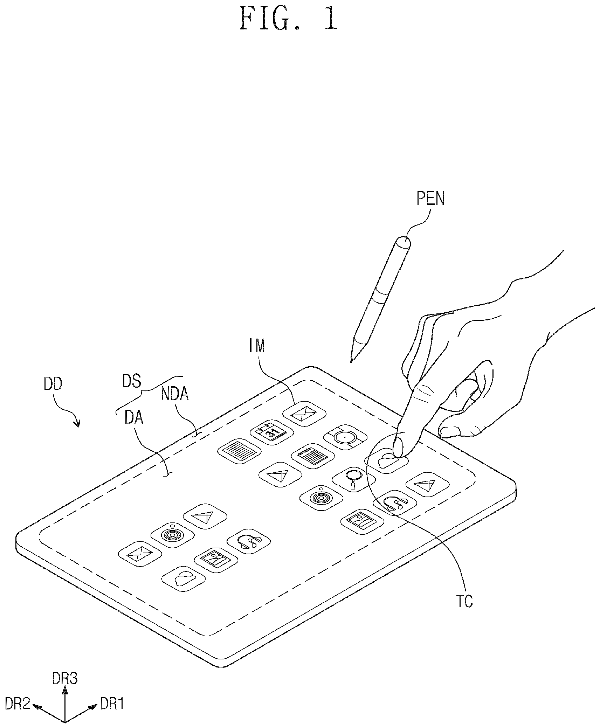

FIG. 1 is a perspective view of a electronic device according to some embodiments of the present disclosure. As illustrated in FIG. 1, a electronic device DD may have long sides extending to be parallel to each other in a first direction DR1, and short sides extending to be parallel to each other in a second direction DR2 crossing the first direction DR1.

Hereinafter, a third direction DR3 is defined as a direction substantially perpendicularly crossing a plane defined by the first direction DR1 and the second direction DR2. The phrase "when viewed in a plan view" used herein may be defined as a state when viewed in the third direction DR3.

A front surface of the electronic device DD may be defined as a display surface DS, and may have a plane defined by the first direction DR1 and the second direction DR2. Images IM generated through the display surface DS by the electronic device DD may be provided or displayed to a user.

The display surface DS may include a display area DA and a non-display area NDA around the display area DA. The display area DA may be an area at which images are displayed, and the non-display area NDA may be an area at which images are not displayed. The non-display area NDA may be adjacent to at least one side of the display area DA. According to some embodiments, the non-display area NDA may have a frame shape that surrounds (e.g., in a periphery or outside a footprint of) the display area DA.

The electronic device DD may sense inputs applied from the outside of the electronic device DD. For example, the electronic device DD may sense a first input by a touch pen PEN and a second input by a touch TC. Here, the touch pen PEN may be defined as an input device, and besides displaying images, the display area DA may provide a user with a sensing area capable of sensing the inputs.

The touch pen PEN may be an active pen or an electromagnetic pen. The second input by the touch TC may include various types of external inputs such as part of the user's body, light, heat, pressure or the like. The touch pen PEN includes an active pen, a passive pen, an electromagnetic pen, and the like, but embodiments are not limited thereto.

The electronic device DD may be used in large-sized electronic apparatuses such as televisions, monitors, or outdoor billboards. In addition, the electronic device DD may be used in small and medium-sized electronic apparatuses such as personal computers, notebook computers, personal digital assistants, vehicle navigation units, game consoles, smartphones, tablet computers, or cameras. However, this is illustrative, and the electronic device DD according to some embodiments of the present disclosure may be used in various forms, and embodiments are not limited thereto.

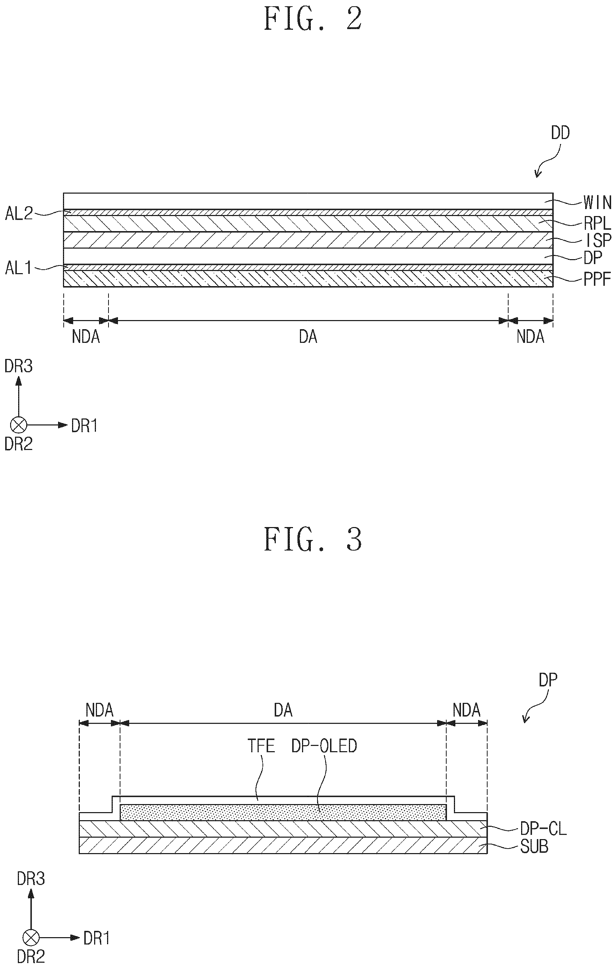

FIG. 2 is a view illustrating an example of a cross-section of the electronic device illustrated in FIG. 1. FIG. 3 is a view illustrating an example of a cross-section of a display panel illustrated in FIG. 2. Aspects of some embodiments of the present disclosure will be described in more detail with reference to FIGS. 2 and 3.

Referring to FIG. 2, the electronic device DD may include a display panel DP, an input sensing part ISP, an anti-reflection layer RPL, a window WIN, a panel protective film PPF, and first and second adhesive layers AL1 and AL2.

The display panel DP according to some embodiments of the present disclosure may be an emissive display panel. For example, the display panel DP may be an organic light emitting display panel or an inorganic light emitting display panel. A light emitting layer of the organic light emitting display panel may include an organic light emitting material. A light emitting layer of the inorganic light emitting display panel may include a quantum dot, a quantum rod, and the like. Hereinafter, an organic light emitting display panel is described as an example of the display panel DP.

Referring to FIG. 3, the display panel DP may include a substrate SUB, a circuit element layer DP-CL located on the substrate SUB, a display element layer DP-OLED located on the circuit element layer DP-CL, and an encapsulating layer TFE located on the display element layer DP-OLED.

The substrate SUB may include a display area DA and a non-display area NDA around (e.g., in a periphery or outside a footprint of) the display area DA. The substrate SUB may include glass, or include a flexible plastic material such as polyimide (PI). The display element layer DP-OLED may be located on the display area DA.

A plurality of pixels may be located in the circuit element layer DP-CL and the display element layer DP-OLED. Each of the pixels may include a transistor located in the circuit element layer DP-CL, and a light emitting element located in the display element layer DP-OLED to be connected to the transistor.

The encapsulating layer TFE may be located on the circuit element layer DP-CL so as to cover the display element layer DP-OLED. The encapsulation layer TFE may protect the pixels from moisture, oxygen, and external foreign matters. According to some embodiments, the encapsulating layer TFE may be a thin film encapsulating layer in which a plurality of thin films are stacked. According to some embodiments, the encapsulating layer TFE is illustrated as covering the entire area of the substrate SUB. However, according to some embodiments of the present disclosure, the substrate SUB may include a partial area exposed from the encapsulating layer TFE. The area exposed from the encapsulating layer TFE may be also provided along an edge of the substrate SUB. The encapsulating layer TFE of embodiments is not limited thereto.

The input sensing part ISP may be located on the display panel DP. The input sensing part ISP may include a plurality of sensors for sensing an external input by using a capacitance method. The input sensing part ISP may be provided directly on the display panel DP during manufacture of the electronic device DD. For example, a conductive pattern or an insulation layer, which constitutes the input sensing part ISP, may be deposited or patterned directly in the display panel DP. However, the embodiments of the present disclosure are not limited thereto, and the input sensing part ISP may be manufactured as a separate panel from the display panel DP to be attached to the display panel DP through an adhesive layer.

The anti-reflection layer RPL may be located on the input sensing part ISP. The anti-reflection layer RPL may reduce an external light reflectance of the electronic device DD to relatively improve visibility of an image displayed on the electronic device DD. The anti-reflection layer RPL may include a retarder, a polarizer, a black matrix, color filters, and the like, and embodiments are not limited thereto. The anti-reflection layer RPL may be formed directly on the input sensing part ISP through a process such as coating or deposition, or be provided in the form of a film to be attached to the input sensing part ISP through an adhesive layer, and embodiments are not limited thereto.

The window WIN may be located on the anti-reflective layer RPL. The window WIN may protect the display panel DP, the input sensing part ISP, and the anti-reflection layer RPL from an external scratch and impact.

The panel protective film PPF may be located below the display panel DP. The panel protective layer PPF may support the display panel DP and protect a lower portion of the display panel DP. The panel protective layer PPF may have insulating properties. For example, the panel protective layer PPF may include plastic such as polyethyleneterephthalate (PET), polyimide (PI), or polypropylene (PP), but embodiments are not limited thereto.

The first adhesive layer AL1 may be located between the display panel DP and the panel protective film PPF, and the display panel DP and the panel protective layer film PPF may be bonded to each other through the first adhesive layer AL1. The second adhesive layer AL2 may be located between the window WIN and the anti-reflection layer RPL, and the window WIN and the anti-reflection layer RPL may be bonded to each other through the second adhesive layer AL2.

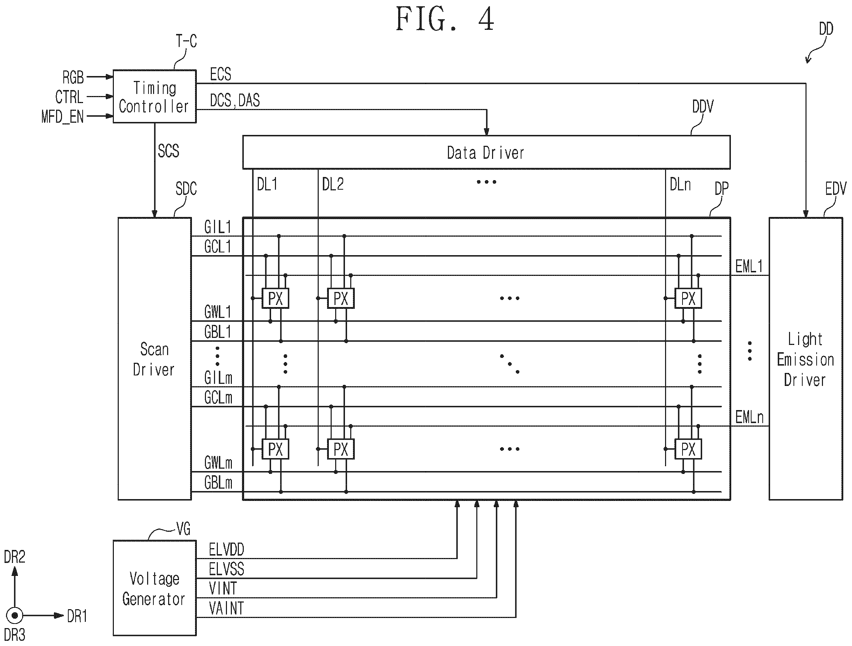

FIG. 4 is a block diagram of the electronic device illustrated in FIG. 1. Referring to FIG. 4, the electronic device DD may include a display panel DP, a timing controller T-C, a scan driver SDV, a data driver DDV, a light emission driver EDV, and a voltage generator VG.

The display panel DP may include a plurality of scan lines GIL1 to GILm, GCL1 to GCLm, GWL1 to GWLm and GBL1 to GBLm, a plurality of light emission lines EML1 to EMLm, a plurality of data lines DL1 to DLn, and a plurality of pixels PX. Here, m and n are each a natural number.

The pixels PX may be electrically connected to the scan lines GIL1 to GILm, GCL1 to GCLm, GWL1 to GWLm and GBL1 to GBLm, the light emission lines EML1 to EMLm, and the data lines DL1 to DLn, respectively. Each of the pixels PX may be electrically connected to four corresponding scan lines, one corresponding data line, and one corresponding light emitting line.

The scan lines GIL1 to GILm, GCL1 to GCLm, GWL1 to GWLm and GBL1 to GBLm may include a plurality of initialization scan lines GIL1 to GILm, a plurality of compensation scan lines GCL1 to GCLm, a plurality of write scan lines GWL1 to GWLm, and a plurality of bias scan lines GBL1 to GBLm.

Each of the pixels PX may be connected to a corresponding one of the initialization scan lines GIL1 to GILm, a corresponding one of the compensation scan lines GCL1 to GCLm, a corresponding one of the write scan lines GWL1 to GWLm, and a corresponding one of the bias scan lines GBL1 to GBLm.

The scan lines GIL1 to GILm, GCL1 to GCLm, GWL1 to GWLm and GBL1 to GBLm may be connected to the scan driver SDV, and extend in the first direction DR1 to be arranged in the second direction DR2. The light emission lines EML1 to EMLm may be connected to the light emission driver EDV, and extend in the first direction DR1 to be arranged in the second direction DR2. The data lines DL1 to DLn may be connected to the data driver DDV, and extend in the second direction DR2 to be arranged in the first direction DR1.

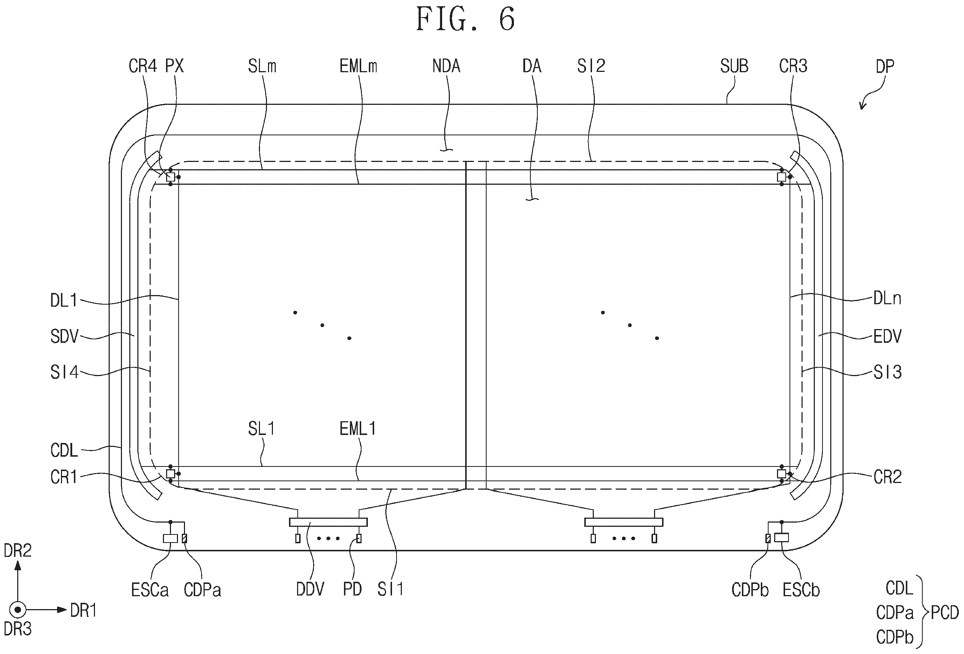

The scan driver SDV, the light emission driver EDV, and the data driver DDV may be substantially located in the display panel DP, and this configuration will be illustrated later in FIG. 6.

The timing controller T-C may receive an image signal RGB and a control signal CTRL. The timing controller T-C may generate an image data signal DAS obtained by converting a data format of the image signal RGB to match an interface specification of the data driver DDV. The timing controller T-C may output a scan control signal SCS, a data control signal DCS, and a light emission control signal ECS in response to the control signal CTRL.

The voltage generator VG may generate voltages required for an operation of the display panel DP. The voltage generator VG may generate a first driving voltage ELVDD, a second driving voltage ELVSS, a first initialization voltage VINT, and a second initialization voltage VAINT. The first driving voltage ELVDD, the second driving voltage ELVSS, the first initialization voltage VINT, and the second initialization voltage VAINT may be applied to the pixels PX.

The scan driver SDV may receive the scan control signal SCS from the timing controller T-C. The scan driver SDV may output scan signals to the scan lines GIL1 to GILm, GCL1 to GCLm, GWL1 to GWLm and GBL1 to GBLm in response to the scan control signal SCS. The scan signals may be applied to the pixels PX through the scan lines GIL1 to GILm, GCL1 to GCLm, GWL1 to GWLm and GBL1 to GBLm.

The data driver DDV may receive the data control signal DCS and the image data signal DAS from the timing controller T-C. The data driver DDV may convert the image data signal DAS into data signals to output the data signals. The data signals may be defined as analog voltages corresponding to gray levels of the image data signal DAS. The data signals may be applied to the pixels PX through the data lines DL1 to DLn.

The light emission driver EDV may receive the light emission control signal ECS from the timing controller T-C. The light emission driver EDV may output light emission signals to the light emission lines EML1 to EMLm in response to the light emission control signal ECS. The light emission signals may be applied to the pixels PX through the light emission lines EML1 to EMLm.

The pixels PX may receive the data voltages in response to the scan signals. The pixels PX may display an image by emitting light with luminance corresponding to the data voltages in response to the light emission signals.

Each of the pixels PX may include a light emitting element, and a pixel circuit that drives the light emitting element. The light emitting element may be an organic light emitting element. However, the light emitting element may be an inorganic light emitting element according to some embodiments of the present disclosure, and embodiments are not limited thereto.

The pixel circuit may include a transistor and a capacitor. The transistor may be provided in plurality. The plurality of transistors and the capacitor may control an amount of current flowing through the light emitting element, and the light emitting element may generate light having a luminance (e.g., a set or predetermined luminance) according to an amount of current applied thereto.

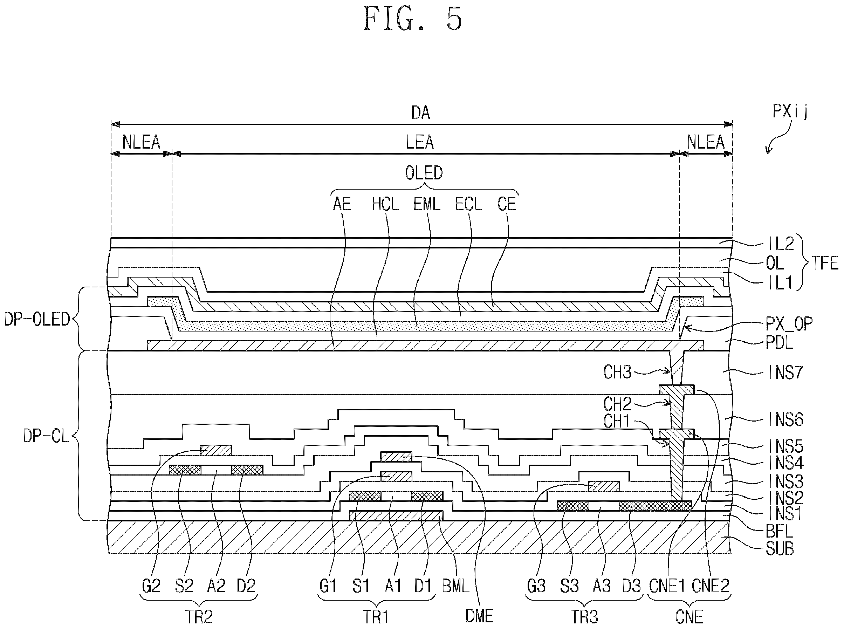

FIG. 5 is a view illustrating an example of a cross-section of a display panel corresponding to a partial area of a pixel illustrated in FIG. 4. These embodiments are illustrative of an area on which among components of a pixel PXij, three transistors TR1, TR2 and TR3 and a light emitting element OLED are located. Referring to FIG. 5, a display panel DP may include a substrate SUB, a circuit element layer DP-CL, a display element layer DP-OLED, and an encapsulating layer TFE.

The substrate SUB may include a glass substrate, a sapphire substrate, a plastic film, or an organic/inorganic stacked film. The substrate SUB may have a multilayer structure or a single-layer structure. For example, the substrate SUB may have a structure in which a plurality of plastic films coupled to each other through an adhesive are stacked, or a structure in which a glass substrate and a plastic film coupled to each other through an adhesive are stacked. The substrate SUB may have flexibility. For example, the substrate SUB may include polyimide (PI). However, this is illustrative, and the substrate SUB may be provided in a rigid state and embodiments are not limited thereto.

The circuit element layer DP-CL is located on the substrate SUB. The circuit element layer DP-CL may include a driving element and a plurality of insulation layers. The above-mentioned three transistors TR1, TR2 and TR3 may be elements that constitute the circuit element layer DP-CL. The insulation layers may include an auxiliary layer BFL and first to seventh insulation layers INS1 to INS7, which are stacked in sequence on the substrate SUB. However, this is illustrative, and the number of the insulation layers that constitute the circuit element layer DP-CL may be variously changed, and embodiments are not limited thereto.

The three transistors TR1, TR2 and TR3 are located on the substrate SUB. The three transistors TR1, TR2 and TR3 include a first transistor TR1, a second transistor TR2, and a third transistor TR3. According to some embodiments, a lower blocking layer BML and an auxiliary layer BFL may be further located between the three transistors TR1, TR2 and TR3 and the substrate SUB.

The lower blocking layer BML may block light incident on the first transistor TR1 from below the lower blocking layer BML. The lower blocking layer BML may be a light blocking pattern, and may include a black matrix and a reflective conductive material. In a case in which the lower blocking layer BML includes a conductive material, the lower blocking layer BML may be electrically floated, or be connected to the first transistor TR1. For example, the lower blocking layer BML may be connected to one of a source, a gate, and a drain of the first transistor TR1. However, this is illustrative, and the lower blocking layer BML may be omitted in the display panel according to some embodiments of the present disclosure, and embodiments are not limited thereto.

The auxiliary layer BFL is located on the substrate SUB to cover the lower blocking layer BML. The auxiliary layer BFL may entirely cover the substrate SUB. The auxiliary layer BFL may include a barrier layer and/or a buffer layer. Accordingly, the auxiliary layer BFL may prevent or reduce instances of contaminants such as oxygen or moisture introduced through the substrate SUB permeating the pixel PXij, or may reduce surface energy of the substrate SUB so that the pixel PXij is stably provided on the substrate SUB. At least one of the barrier layer or the buffer layer may be provided in plurality, or may be omitted. The auxiliary layer BFL may be omitted in the display panel according to some embodiments of the present disclosure, and embodiments are not limited thereto.

The first transistor TR1 may include a semiconductor pattern and a first gate G1. The first transistor TR1 may be a driving transistor that is located on a current path between a first power line and the light emitting element OLED to control an amount of current flowing through the light emitting element OLED as described above, but the first transistor TR1 of embodiments is not limited thereto. The first power line may be one of power lines connected to the voltage generator VG, such as a line transmitting the first driving voltage ELVDD. The semiconductor pattern includes a first source S1, a first drain D1, and a first channel A1.

According to some embodiments, the semiconductor pattern of the first transistor TR1 may include silicon. For example, the semiconductor pattern of the first transistor TR1 may be polycrystalline silicon. However, this is illustrative, and the semiconductor pattern of the first transistor TR1 may be amorphous silicon or include an oxide semiconductor, and embodiments are not limited thereto.

Each of the first source S1 and the first drain D1 may be a heavy doped region having a relatively high dopant concentration compared to the first channel A1. The heavy doped regions may each have conductivity higher than conductivity of the first channel A1, which becomes a light doped region, and thus substantially serve as source/drain. That is, the source and the drain of the first transistor TR1 may be provided in the semiconductor pattern. However, this is illustrative, and the source/drain of the first transistor TR1 may be provided as separate conductive patterns connected to the semiconductor pattern, and embodiments are not limited thereto.

The first gate G1 may be located on the semiconductor pattern of the first transistor TR1. The first gate G1 may overlap the first channel A1. The first insulation layer INS1 may be located between the first gate G1 and the semiconductor pattern. The first insulation layer INS1 may be a gate insulation layer, and the first transistor TR1 is illustrated in a top-gate structure. However, this is illustrative, and the first transistor TR1 may have a bottom-gate structure, and embodiments are not limited thereto.

An upper electrode DME may be located on the first transistor TR1. The upper electrode DME is arranged to overlap the first gate G1 with the second insulation layer INS2 therebetween. The second insulation layer INS2 is located on the first insulation layer INS1 to cover the first transistor TR1.

A portion on which the upper electrode DME and the first gate G1 overlap each other in a plan view may function as a capacitor that constitutes the pixel circuit. According to some embodiments of the present disclosure, as the capacitor is provided together with the first gate G1 of the first transistor TR1, a surface area of the capacitor may be secured, and also a high-resolution pixel circuit may be designed. However, this is illustrative. For example, the upper electrode DME may be omitted, or the capacitor may be provided at other position, and the embodiments of the present disclosure are not limited thereto.

The second transistor TR2 may include a second gate G2 and a semiconductor pattern. The second transistor TR2 may be an initialization transistor that is turned on through a corresponding initialization scan line of the above-mentioned initialization scan lines GIL1 to GILm to provide the pixel circuit with a first initialization voltage VINT delivered through a first initialization line. However, the embodiments of the present disclosure are not limited thereto.

The semiconductor pattern of the second transistor TR2 may be located on a different layer from the semiconductor pattern of the first transistor TR1. According to some embodiments, the semiconductor pattern of the second transistor TR2 is located on the third insulation layer INS3. The third insulation layer INS3 is located on the second insulation layer INS2 to cover the upper electrode DME. The semiconductor pattern of the second transistor TR2 may include a metal oxide semiconductor. The metal oxide semiconductor may include a crystalline or amorphous oxide semiconductor.

The semiconductor pattern of the second transistor TR2 may include a plurality of regions divided according to whether a metal oxide is reduced. A region in which the metal oxide is reduced (hereinafter referred to as a reduced region) may have higher conductivity than a region in which the metal oxide is not reduced (hereinafter referred to as a non-reduced region). The reduced region may substantially serve as a source or drain of the second transistor TR2. The non-reduced region may substantially correspond to an active (or channel) of the second transistor TR2. That is, the source and drain of the second transistor TR2 may be provided in the semiconductor pattern. However, this is illustrative, and the source/drain of the second transistor TR2 may be provided as separate conductive patterns connected to the semiconductor pattern, and embodiments are not limited thereto.

The second gate G2 may be located on the semiconductor pattern of the second transistor TR2. The second gate G2 may overlap a second channel A2. In a case in which the second transistor TR2 is the initialization transistor, the second gate G2 may be connected to a corresponding initialization scan line of the above-mentioned initialization scan lines GIL1 to GILm. The fourth insulation layer INS4 may be located between the second gate G2 and the semiconductor pattern. The fifth insulation layer INS5 is located on the fourth insulation layer INS4 to cover the second transistor TR2. The fourth insulation layer INS4 may be a gate insulation layer, and the second transistor TR2 is illustrated in a top-gate structure. However, this is illustrative, and the second transistor TR2 may have a bottom-gate structure, and embodiments are not limited thereto.

The third transistor TR3 may include a third gate G3 and a semiconductor pattern. The third transistor TR3 may be a light emission control transistor that is located on a current path between the first transistor TR1 and the light emitting element OLED and provides the light emitting element OLED with driving current that the first transistor TR1 transfers in response to a signal transmitted through a corresponding light emission line of the above-mentioned light emission lines EML1 to EMLm. However, the embodiments of the present disclosure are not limited thereto.

The third transistor TR3 may be provided in the same structure as the first transistor TR1. For example, the third transistor TR3 may have a top-gate structure, include a semiconductor pattern located on the same layer as the first transistor TR1, and include a third source S3, a third drain D3, and a third channel A3 that are provided in the semiconductor pattern. The semiconductor pattern of the first transistor TR1 and the semiconductor pattern of the third transistor TR3 may include the same material as each other, and be patterned at the same time. However, this is illustrative, and the semiconductor pattern of the third transistor TR3 may include a different material from the semiconductor pattern of the first transistor TR1, and embodiments are not limited thereto.

According to some embodiments, each of the auxiliary layer BFL and the first to fifth insulation layers INS1 to INS5 may include an inorganic layer. As an example, each of the auxiliary layer BFL, the first insulation layer INS1, and the fourth insulation layer INS4 may include a silicon oxide layer, and the second insulation layer INS2 may include a silicon nitride layer.

Each of the third and fifth insulation layers INS3 and INS5 may include a plurality of inorganic insulation layers that include different materials from each other and are stacked on each other. For example, the third insulation layer INS3 may include a silicon nitride layer and a silicon oxide layer which are stacked in sequence, and the fifth insulation layer INS5 may include a silicon oxide layer and a silicon nitride layer which are stacked in sequence. Each of the third and fifth insulation layers INS3 and INS5 may have a thickness greater than a thickness of each of the auxiliary layer BFL and the first, second, and fourth insulation layers INS1, INS2 and INS4. However, this is illustrative, and the respective materials or the stacked shape of the auxiliary layer BFL and the first to fifth insulation layers INS1 to INS5 may be variously changed, and embodiments are not limited thereto.

The third transistor TR3 may be connected to the light emitting element OLED through a connection electrode CNE. The connection electrode CNE may include a first connection electrode CNE1 and a second connection electrode CNE2.

The first connection electrode CNE1 may be located on the fifth insulation layer INS5, and connected to the third drain region D3 through a first contact hole CH1 defined in the first to fifth insulation layers INS1 to INS5. The sixth insulation layer INS6 may be located on the fifth insulation layer INS5 so as to cover the first connection electrode CNE1.

The second connection electrode CNE2 may be located on the sixth insulation layer INS6. The second connection electrode CNE2 may be connected to the first connection electrode CNE1 through a second contact hole CH2 defined in the sixth insulation layer INS6. The seventh insulation layer INS7 may be located on the sixth insulation layer INS6 so as to cover the second connection electrode CNE2. The sixth and seventh insulation layers INS6 and INS7 may each include an inorganic layer or an organic layer.

A first electrode AE may be located on the seventh insulation layer INS7. The first electrode AE may be electrically connected to the second connection electrode CNE2 through a third contact hole CH3 defined in the seventh insulation layer INS7. However, this is illustrative, and as long as being capable of connecting the third transistor TR3 and the light emitting element OLED to each other, the connection electrode CNE may be provided as a single connection electrode or three or more connection electrodes, and embodiments are not limited thereto.

The display element layer DP-OLED may be located on the circuit element layer DP-CL. The display element layer DP-OLED may include the light emitting element OLED and a pixel defining film PDL. The light emitting element OLED may include the first electrode AE, a hole control layer HCL, a light emitting layer EML, an electron control layer ECL, and a second electrode CE.

The pixel defining film PDL that exposes a portion (e.g., a set or predetermined portion) of the first electrode AE may be located on the first electrode AE and the seventh insulation layer INS7. An opening portion PX_OP for exposing the portion (e.g., the set or predetermined portion) of the first electrode AE may be defined in the pixel defining film PDL.

The hole control layer HCL may be located on the first electrode AE and the pixel defining film PDL. The hole control layer HCL may be located, in common, in an emissive area LEA and a non-emissive area NLEA. The hole control layer HCL may include a layer having a high hole mobility to allow holes to easily move from the first electrode AE to the light emitting layer EML. For example, the hole control layer HCL may include at least one of a hole transport layer, a hole injection layer, or an electron blocking layer, and each of the layers may have a single-layer structure or a multilayer structure in which layers are stacked.

The light emitting layer EML may be located on the hole control layer HCL. The light emitting layer EML may be located in an area corresponding to the opening portion PX_OP. The light emitting layer EML may include an organic material and/or an inorganic material. The light emitting layer EML may generate light having one of red, green, and blue colors.

The electron control layer ECL may be located on the light emitting layer EML and the hole control layer HCL. The electron control layer ECL may be arranged, in common, in the emission area LEA and the non-emission area NLEA. The electron control layer ECL may include a layer having a high electron mobility to allow electrons to easily move from the second electrode CE to the light emitting layer EML. For example, the electron control layer ECL may include at least one of an electron transport layer, an electron injection layer, or a hole blocking layer, and each of the layers may have a single-layer structure or a multilayer structure in which layers are stacked.

The second electrode CE may be located on the electron control layer ECL. The second electrode CE may be arranged in the pixels PX in common. That is, the second electrode CE may be provided in the form of one body on the light emitting layers EML of the pixels PX. However, this is illustrative, and the second electrode CE may be provided as a separate pattern for each of the pixels PX, and embodiments are not limited thereto. The second electrode CE may be semi-transmissive or transmissive. The second electrode CE may be provided in various forms, for example, a transparent conductive oxide layer, a metal layer that is transmissive and has a thin-film thickness, or a layer having a structure in which metal layer/oxide layer are stacked. In a case in which the light emitting element OLED has a bottom-emission structure, the second electrode CE may be a reflective electrode.

The encapsulating layer TFE may be located on the display element layer DP-OLED. The encapsulating layer TFE may include an inorganic layer and an organic layer. These embodiments are illustrative of a shape in which a first inorganic layer IL1, an organic layer OL, and a second inorganic layer IL2 are stacked in sequence, but the structure in which layers that constitute the encapsulating layer TFE are stacked may be variously changed.

The first inorganic layer IL1 and the second inorganic layer IL2 may each include an inorganic material, and protect the pixels from moisture/oxygen. The first inorganic layer IL1 and the second inorganic layer IL2 may include the same material as each other, or may include different materials from each other. The organic layer OL may include an organic material, and protect the display element layer DP-OLED or the circuit element layer DP-CL from foreign matters.

FIG. 6 is a plan view of a display panel illustrated in FIG. 1. Referring to FIG. 6, a electronic device DD may include a display panel DP, a scan driver SDV, a plurality of data drivers DDV, a light emission driver EDV, and a plurality of pads PD.

According to some embodiments, a display area DA may have a rectangular shape with corners each having a curved shape. For example, the display area DA may include sides of a rectangle extending in the first direction DR1 and the second direction DR2, and rounded-shaped corners which connect the sides. According to some embodiments, an edge of the display area DA may include long sides SI1 and SI2 extending in the first direction DR1, short sides SI3 and SI4 extending in the second direction DR2, and corner portions CR1, CR2, CR3 and CR4 connected to the sides, respectively. However, this is illustrative, and the display area DA may have a rectangular shape with angular corners to be different from the shape of the electronic device DD, and embodiments are not limited thereto.

The display panel DP may include a plurality of pixels PX, a plurality of scan lines SL1 to SLm, a plurality of data lines DL1 to DLn, and a plurality of light emission lines EML1 to EMLm. The pixels PX may be located within the display area DA. The pixels PX may be connected to the scan lines SL1 to SLm, the data lines DL1 to DLn, and the light emission lines EML1 to EMLm.

The scan lines SL1 to SLm may include the scan lines GIL1 to GILm, GCL1 to GCLm, GWL1 to GWLm and GBL1 to GBLm illustrated in FIG. 4. For example, an i-th scan line of the scan lines SL1 to SLm may include the i-th write scan lines GWLi, the i-th compensation scan line GCLi, the i-th initialization scan line GILi, and the i-th bias scan line GBLi, described above. Thus, the above-mentioned scan signals may be applied to the pixels PX through the scan lines SL1 to SLm. The data lines DL1 to DLn and the light emission lines EML1 to EMLm may be the same as the data lines DL1 to DLn and the light emission lines EML1 to EMLm illustrated in FIG. 4.

The scan driver SDV and the light emission driver EDV may be located, respectively, on non-display areas NDA adjacent to both sides of the display panel DP which are opposite each other in the first direction DR1. The scan driver SDV and the light emission driver EDV are illustrated in a shape in which respective upper sides and lower sides thereof are curved to correspond to the shapes of the curved-shaped corner portions CR1 to CR4 of the display area DA. However, the respective shapes of the scan driver SDV and the light emission driver EDV of embodiments are not limited thereto.

The data driver DDV may be provided in plurality for the display panel DP. The data drivers DDV may be located on the non-display area NDA adjacent to one of both sides of the display panel DP which are opposite each other in the second direction DR2. The data drivers DDV may be adjacent to a lower end of the display panel DP when viewed in a plan view. However, this is illustrative. For example, the data driver DDV may be provided in one or may be provided to a separate circuit substrate and bonded to the display panel DP to be connected to the pixels PX, and embodiments are not limited thereto.

The scan lines SL1 to SLm may extend in the first direction DR1 to be connected to the pixels PX and the scan driver SDV. The data lines DL1 to DLn may extend in the second direction DR2 to be connected to the pixels PX and the data drivers DDV. The light emission lines EML1 to EMLm may extend in the first direction DR1 to be connected to the pixels PX and the light emission driver EDV.

The data drivers DDV may be spaced apart from each other in the first direction DR1. A number (e.g., a set or predetermined number) of data lines may be connected to each of the data drivers DDV. Although two data drivers DDV are illustrated as an example, the number of the data drivers DDV of embodiments is not limited thereto. For example, as a left and right surface area of the display panel DP increases, the number of the data drivers DDV may increase.

The pads PD may be located on the non-display area NDA adjacent to the lower end of the display panel DP, and may be more adjacent to the lower end of the display panel DP than the data drivers DDV are. The data drivers DDV may be connected to the pads PD. The data lines DL1 to DLn may be connected to the data drivers DDV, and the data drivers DDV may be connected to the pads PD that correspond to the data lines DL1 to DLn, respectively.

According to some embodiments, the timing controller T-C and the voltage generator VG, which are illustrated in FIG. 4, may be mounted on a printed circuit board, and connected to the pads PD through the printed circuit board.

As illustrated in FIG. 6, the display panel DP according to some embodiments of the present disclosure may include a crack detecting circuit PCD and antistatic circuits ESCa and ESCb. The crack detecting circuit PCD and the antistatic circuits ESCa and ESCb are located on the non-display area NDA.

The crack detecting circuit PCD may include a crack detecting line CDL, a first pad CDPa, and a second pad CDPb. The crack detecting line CDL may be a conductive line having a shape of one body. That is, the crack detecting line CDL may have one end and the other end. The first pad CDPa and the second pad CDPb may be connected to both the ends of the crack detecting line CDL, respectively.

In a case in which a crack is initiated in the display panel DP, the crack detecting line CDL located on this area may be disconnected or damaged, and resistance of the crack detecting line CDL may be increased. A voltage or current between the first pad CDPa and the second pad CDPb may be measured to inspect whether the resistance of the crack detecting line CDL is increased. The crack detecting line CDL extends along a shape of an edge of the display panel DP. Thus, through the crack detecting line CDL, the crack detecting circuit PCD may detect whether a crack is initiated in the edge of the display panel DP due to an external impact or the like.

The crack initiated in the edge of the display panel DP may become a permeation path of moisture or foreign matters to cause a defect to the pixels PX of the display area DA. In addition, even a fine crack to the extent that does not cause an immediate damage to the display area DA may grow later to the display area DA to lead a decrease in reliability of the display panel DP. As the display panel DP according to some embodiments of the present disclosure includes the crack detecting circuit PCD, whether a damage such as a crack is generated in the edge of the display panel DP may be inspected and managed.

The antistatic circuits ESCa and ESCb are connected to the crack detecting circuit PCD. The antistatic circuits ESCa and ESCb prevent or reduce damage to the crack detecting circuit PCD caused by static electricity generation or the like. Since the crack detecting line CDL has a line shape of one body, on which the one end and the other end are present, and has a shape extending along the edge of the display panel DP as described above, the crack detecting line CDL may be highly likely to be damaged in a case in which static electricity is generated in any one area of the display panel DP. According to some embodiments of the present disclosure, as the antistatic circuits ESCa and ESCb are connected to the crack detecting circuit PCD, the damage to the crack detecting circuit PCD caused by the static electricity generation may be prevented or reduced, and an increase in resistance measured by the crack detecting circuit PCD may be simplified as one only caused by a crack initiated in the display panel DP, thereby reducing an occurrence of an error in detection result of the crack detecting circuit PCD.

According to some embodiments, the antistatic circuits ESCa and ESCb may include a first antistatic circuit ESCa and a second antistatic circuit ESCb. The first antistatic circuit ESCa may be located on an area close to the first pad CDPa, for example, the first antistatic circuit ESCa may overlap the first pad CDPa when viewed in the first direction DR1, and the second antistatic circuit ESCb may be located on an area close to the second pad CDPb, for example, the second antistatic circuit ESCb may overlap the second pad CDPb when viewed in the first direction DR1. According to some embodiments of the present disclosure, as the antistatic circuits ESCa and ESCb are provided in plurality, respective flows of static electricity on the first pad CDPa and the second pad CDPb corresponding to both the ends of the crack detecting circuit PCD may be stably absorbed into the antistatic circuits ESCa and ESCb. Accordingly, electrical reliability of the crack detecting circuit PCD may be relatively improved.

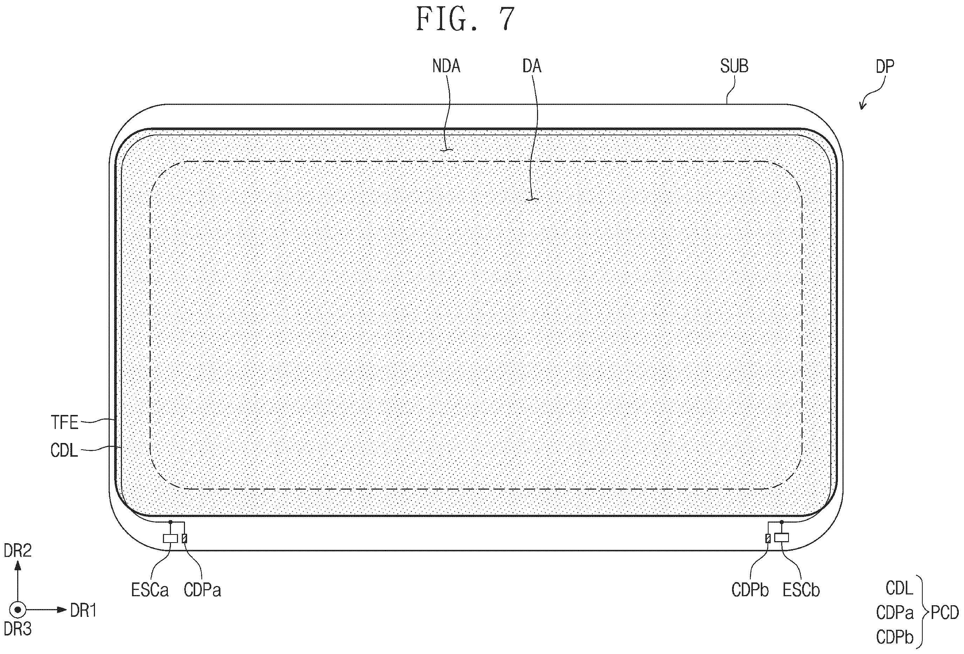

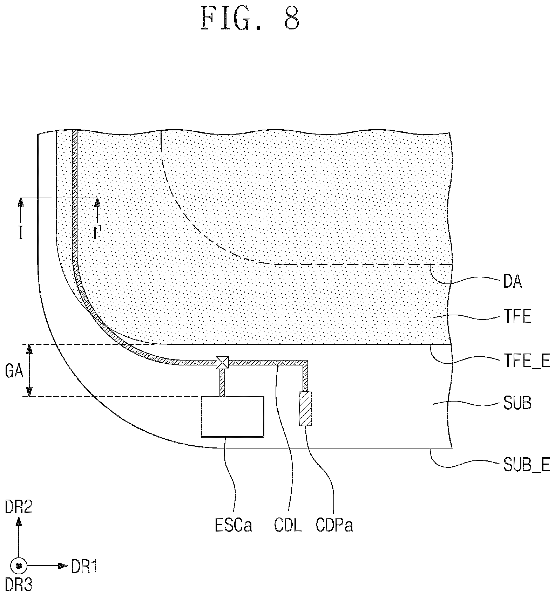

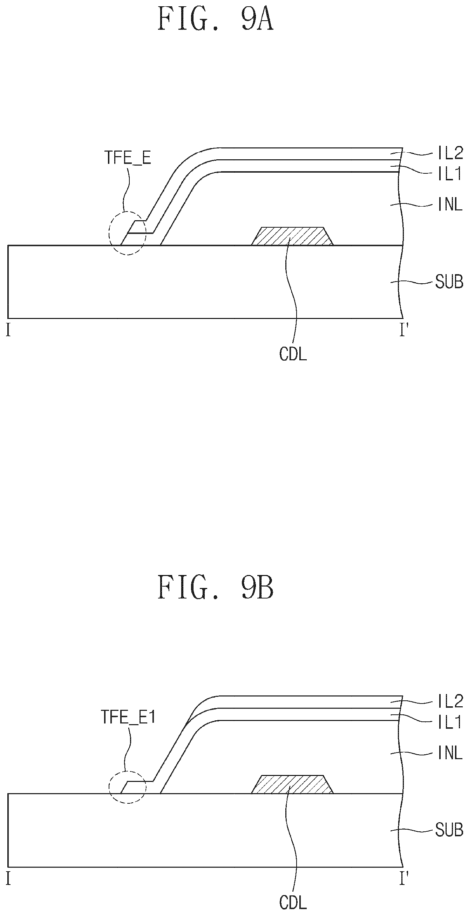

FIG. 7 is a view illustrating some components of the display panel illustrated in FIG. 6. FIG. 8 is an enlarged view illustrating a partial area in FIG. 7. FIGS. 9A to 9C are schematic cross-sectional views illustrating an area taken along line I-I' in FIG. 8. For ease of description, FIG. 7 illustrates only a substrate SUB, an encapsulating layer TFE, a crack s detecting circuit PCD, and antistatic circuits ESCa and ESCb, and illustrates the encapsulating layer TFE by shading. Hereinafter, embodiments according to the present disclosure will be described in more detail with reference to FIGS. 7 to 9C.

As illustrated in FIGS. 7 and 8, the encapsulating layer TFE entirely covers a display area DA, and extends up to the outside of the display area DA. An end TFE_E of the encapsulating layer TFE is defined in a non-display area NDA, and positioned inside an edge SUB_E of the substrate SUB. The end TFE_E of the encapsulating layer TFE may be the ends of the first inorganic layer IL1 and/or the second inorganic layer IL2 described above. An organic layer OL may mostly overlap the display area DA, and not overlap most of the non-display area NDA. Thus, in an area outside the display area DA, the encapsulating layer TFE may be provided in a shape in which the second inorganic layer IL2 is located on the first inorganic layer IL1 to be in direct contact with the first inorganic layer IL1. Thus, the end TFE_E of the encapsulating layer TFE may be the end of the first inorganic layer IL1, the end of the second inorganic layer IL2, or the ends, which are aligned with each other, of the first inorganic layer IL1 and the second inorganic layer IL2.

At least a portion of a crack detecting line CDL of the crack detecting circuit PCD may be covered by the encapsulating layer TFE. According to some embodiments, most of the crack detecting line CDL extending along three sides SI2, SI3 and SI4 of the display area DA may be covered by the encapsulating layer TFE. A component that covers the crack detecting line CDL may be the first inorganic layer IL1 or second inorganic layer IL2 of the encapsulating layer TFE, and the organic layer OL of the encapsulating layer TFE may not overlap the crack detecting line CDL in a plan view.

A first pad CDPa and a second pad CDPb of the crack detecting circuit PCD are exposed from the encapsulating layer TFE. In other words, the first pad CDPa and the second pad CDPb may not overlap the encapsulating layer TFE in a plan view. Accordingly, a connection between an external inspection apparatus for crack inspections and the pad CDPa and CDPb may be easily performed.

The antistatic circuits ESCa and ESCb are arranged not to overlap the end TFE_E of the encapsulating layer TFE in a plan view. Each of the antistatic circuits ESCa and ESCb may be spaced a distance (e.g., a set or predetermined distance) GA from the end TFE_E of the encapsulating layer TFE to be located at a position nonoverlapping the encapsulating layer TFE. The distance GA may be a minimum value of a distance between each of the antistatic circuits ESCa and ESCb and the end TFE_E of the encapsulating layer TFE, and may be more than about 0.

Referring to FIGS. 9A to 9C, an end TFE_E of an encapsulating layer TFE may be defined by an end of an inorganic layer. For ease of description, FIGS. 9A to 9C illustrate only a substrate SUB, a crack detecting line CDL, an insulation layer INL, a first inorganic layer IL1, and a second inorganic layer IL2. The insulation layer INL may be an insulation layer located between the crack detecting line CDL and the encapsulating layer TFE, and may include an organic layer and/or an inorganic layer. For example, the insulation layer INL may include at least one of the sixth insulation layer INS6 (see FIG. 5), the seventh insulation layer INS7, or the pixel defining film PDL described above. Alternatively, the insulation layer INL may include a layer, which is located on the crack detecting line CDL, of the first to fifth insulation layers INS1, INS2, INS3, INS4 and INS5. This is illustrative, and the layer constituting the insulation layer INL of embodiments is not limited to any one embodiment.

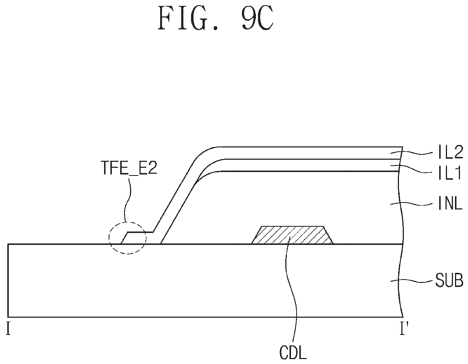

Referring to FIG. 9A, an end TFE_E of the encapsulating layer TFE may be defined by ends of the first inorganic layer IL1 and the second inorganic layer IL2. Here, the ends of the first inorganic layer IL1 and the second inorganic layer IL2 may be aligned with each other. Alternatively, referring to FIG. 9B, an end TFE_E1 of the encapsulating layer TFE may be defined by an end of the first inorganic layer IL1. Alternatively, referring to FIG. 9C, an end TFE_E2 of the encapsulating layer TFE may be defined by an end of the second inorganic layer IL. The ends TFE_E, TFE_E1 and TFE_E2 of the encapsulating layer TFE according to some embodiments of the present disclosure may be provided as various embodiments.

Hereinafter, aspects of some embodiments of the present disclosure will be described based on FIG. 9A for ease of description. The inorganic layers IL1 and IL2 of the encapsulating layer TFE are formed through chemical vapor deposition (CVD) using an open mask, and a shadow phenomenon due to the mask may occur between the outside of a display area DA and the end TFE_E of the encapsulating layer TFE. Accordingly, the closer a position to the end TFE_E of the encapsulating layer TFE, the more likely a region in which the inorganic layers IL1 and IL2 are not deposited or are deposited in a small thickness (hereinafter referred to as a shadow region) may be formed. This shadow region may become a moisture permeation path through which moisture or oxygen is likely to permeate. The permeated oxygen or moisture may oxidize the inorganic layers IL1 and IL2 to damage the inorganic layers IL1 and IL2. In a case in which the inorganic layers IL1 and IL2 are insulation layers each including a nitride, gas such as ammonia may be generated from the inorganic layers IL1 and IL2 or be introduced from the outside during forming the inorganic layers IL1 and IL2 to damage metal patterns located on a lower portion. This is easy to occur in the end TFE_E of the encapsulating layer TFE, which is defined by the ends of the inorganic layers IL1 and IL2. According to some embodiments of the present disclosure, antistatic circuits ESCa and ESCb may be arranged not to overlap the end TFE_E of the encapsulating layer TFE to be designed so that the antistatic circuits ESCa and ESCb are not located in an area vulnerable to the moisture permeation. Thus, the damage to the antistatic circuits ESCa and ESCb may be prevented or reduced, and reliability of the display panel DP may be relatively improved.

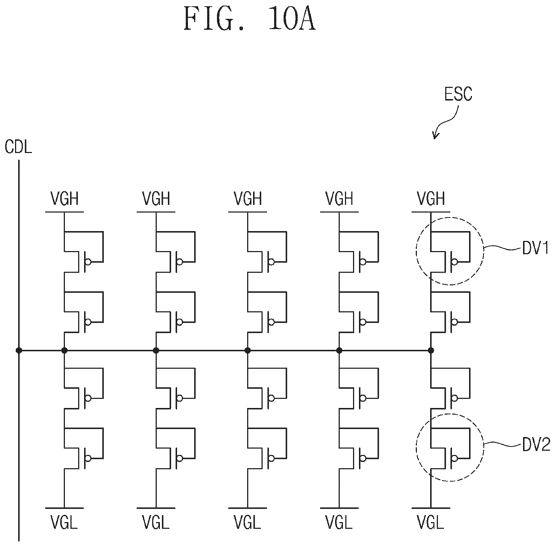

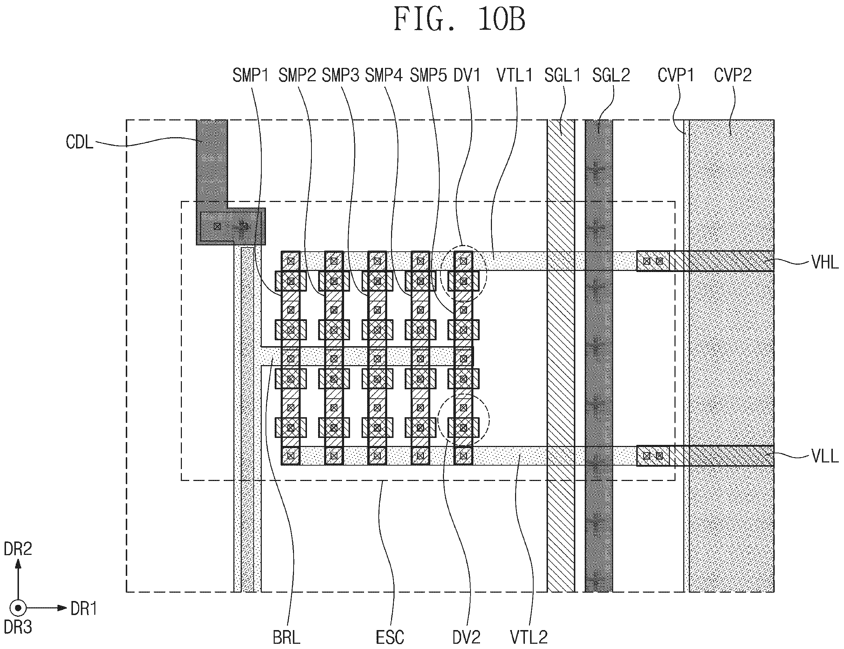

FIG. 10A is a circuit diagram of an antistatic circuit according to some embodiments of the present disclosure. FIG. 10B is a view illustrating a layout of an antistatic circuit according to some embodiments of the present disclosure. Aspects of some embodiments of the present disclosure will be described with reference to FIGS. 10A and 10B.

As illustrated in FIG. 10A, an antistatic circuit ESC may include a plurality of transistors. According to some embodiments, each of the transistors may be a PMOS, or may include a first element DV1 connected to a first voltage terminal VGH, and a second element DV2 connected to a second voltage terminal VGL.

The first element DV1 is connected between a line connected to a crack detecting line CDL and the first voltage terminal VGH, and includes a gate connected to a source or a drain. That is, the first element DV1 may perform substantially the same operation as a diode. The first element DV1 may discharge static electricity, which is supplied to the crack detecting line CDL, through the first voltage terminal VGH.

The second element DV2 is connected between the line connected to the crack detecting line CDL and the second voltage terminal VGL, and includes a gate connected to a source or a drain. That is, the second element DV2 may perform substantially the same operation as a diode. The second element DV2 may discharge static electricity, which is supplied to the crack detecting line CDL, through the second voltage terminal VGL.

The first voltage terminal VGH may provide a first voltage, and the second voltage terminal VGL may provide a second voltage lower than the first voltage. Each of the first voltage and the second voltage may be a constant voltage. Each of the first voltage and the second voltage may be one of the scan control signals SCS (see FIG. 4). That is, a portion of a signal line supplied to the scan driver SDV (see FIG. 4) may be branched to function as the first and second voltage terminals VGH and VGL of the antistatic circuit.

Referring to FIG. 10B, an example layout of an antistatic circuit ESC is illustrated. A first voltage transmission line VTL1 and a second voltage transmission line VTL2 each extending in the first direction DR1 may be connected, respectively, to both ends of each of five semiconductor patterns SMP1 to SMP5 arranged in the first direction DR1. The first voltage transmission line VTL1 and the second voltage transmission line VTL2 may be connected to a first voltage line VHL and a second voltage line VLL to provide a first voltage terminal VGH and a second voltage terminal VGL, respectively. According to some embodiments, the first voltage line VHL and the second voltage line VLL may be located on the same layer and include the same material as the above-mentioned first connection electrode CNE1 (see FIG. 5), but embodiments according to the present disclosure are not limited thereto.

According to some embodiments, each of the first voltage transmission line VTL1 and the second voltage transmission line VTL2 may insulatedly cross signal lines SGL1 and SGL2 each extending in the second direction DR2. In a plan view, the first voltage line VHL and the second voltage line VLL may overlap conductive patterns (e.g., set or predetermined conductive patterns) CVP1 and CVP2 that are located on different layers from each other. The signal lines SGL1 and SGL2 or the conductive patterns CVP1 and CVP2 may be components that transmit electrical signals to different elements from the antistatic circuits ESC. However, this is illustrative, and the first voltage transmission line VTL1, the second voltage transmission line VTL2, the first voltage line VHL, and the second voltage line VLL may be arranged not to overlap the signal lines SGL1 and SGL2 or the conductive patterns CVP1 and CVP2, and embodiments are not limited thereto.

A branch line BRL across centers of the five semiconductor patterns SMP1 to SMP5 to be connected to each of the semiconductor patterns SMP1 to SMP5 is connected to the crack detecting line CDL. According to some embodiments, the branch line BRL is illustrated as including a first portion extending in the second direction DR2 to be connected to the crack detecting line CDL, and a second portion having a shape of one body together with the first portion and extending in the first direction DR1 to be connected to each of the semiconductor patterns SMP1 to SMP5. However, as long as being capable of connecting the crack detecting line CDL and the antistatic circuit ESC, the branch line BRL may have various shapes, and embodiments are not limited thereto.

A plurality of PMOS transistors, each of which performs the same operation as a diode, may be provided on each of the semiconductor patterns SMP1 to SMP5. Each of the PMOS transistors may be a first element DV1 or a second element DV2. Each of the first element DV1 and the second element DV2 may have the same layer structure as the first transistor TR1 (see FIG. 5). That is, each of the first element DV1 and the second element DV2 may be located on the same layer as the first transistor TR1 and include a semiconductor pattern and a gate, each of which includes the same material as the first transistor TR1, but embodiments are not limited thereto.

An element constituting the antistatic circuit ESC according to some embodiments of the present disclosure may be a NMOS transistor, or may include a diode. As long as being capable of stably discharging the static electricity of the crack detecting line CDL, the antistatic circuit ESC may be provided in various shapes, and embodiments are not limited thereto.

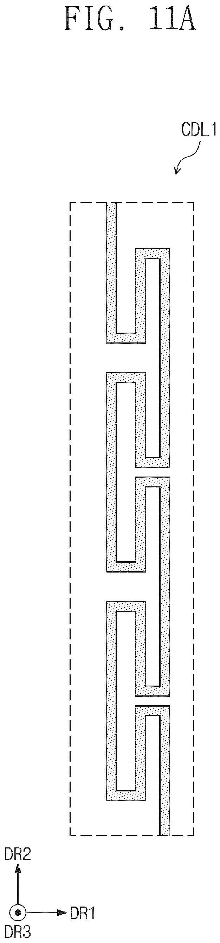

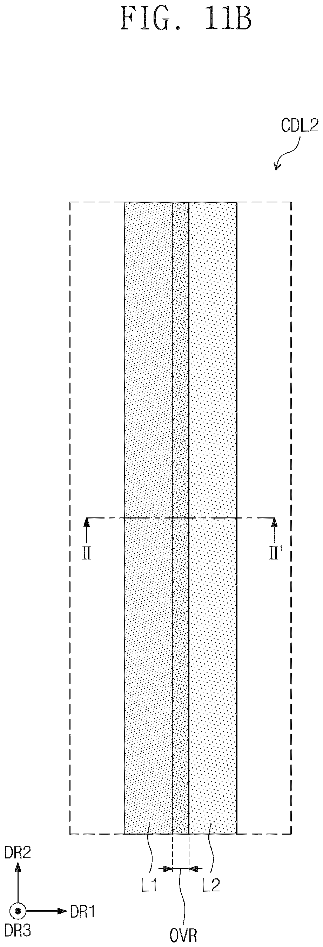

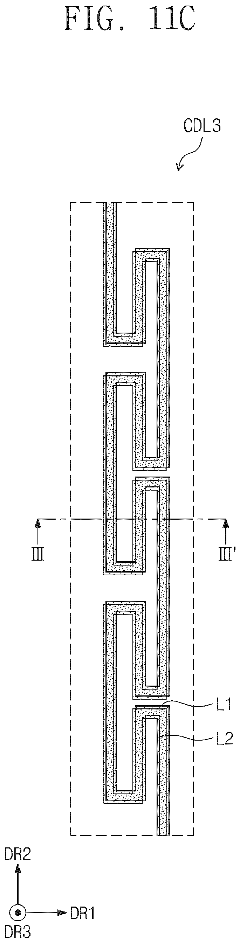

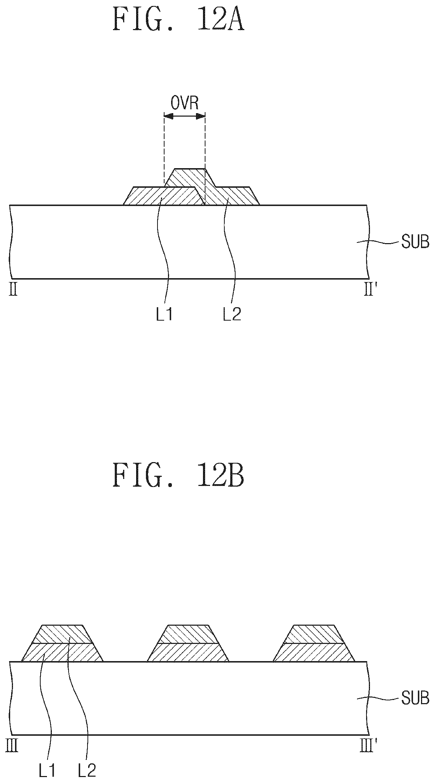

FIGS. 11A to 11C are plan views illustrating a partial area of a crack detecting line according to some embodiments of the present disclosure. FIG. 12A is a schematic cross-sectional view illustrating the crack detecting line taken along line II-II'in FIG. 11B. FIG. 12B is a schematic cross-sectional view illustrating the crack detecting line taken along line III-III' in FIG. 11C. Hereinafter, aspects of some embodiments of the present disclosure will be described in more detail with reference to FIGS. 11A to 12B.

Referring to FIG. 11A, a crack detecting line CDL1 may include a plurality of bending portions in an extending direction thereof. FIG. 11A illustrates an area in which the extending direction of the crack detecting line CDL1 is the second direction DR2. The crack detecting line CDL1 may have a shape that is convex or convexly bent in the first direction DR1, for example, the crack detecting line CDL1 may be concave or convex toward the display area DA. According to some embodiments of the present disclosure, as the crack detecting line has a shape including the bending portions, a length of a path through which the crack detecting line passes may be increased with respect to the same surface area. In addition, a width of the crack detecting line may be decreased to overcome a defect in which a decrease in resistance of the crack detecting line does not occur even when a crack having a fine size is initiated. Thus, crack initiation sensitivity of the crack detecting circuit may be relatively improved, and the display panel with relatively improved reliability may be provided.

Referring to FIGS. 11B and 12A, a crack detecting line CDL2 may include a plurality of lines that are in contact with each other. FIG. 11B illustrates aspects of embodiments in which the crack detecting line CDL2 include a first line L1 and a second line L2. The first line L1 and the second line L2 may be located on the same layer to have at least portions overlapping each other so that the first line L1 and the second line L2 are in physical contact with each other. Thus, an overlapping region OVR may be present at least partially in the crack detecting line CDL2.

According to some embodiments of the present disclosure, in a case in which a plurality of lines each having a small width are provided, a probability of detecting a crack may be relatively improved, and a crack having a fine size may be easily detected, compared to a case in which one line as one body having a large width is provided. The number of the lines constituting the crack detecting line CDL2 may be further increased, and as the number of the lines is increased, the width of each of the lines may be decreased. As long as being capable of detecting a fine crack having a size which is likely to affect the display panel, the lines may be variously designed in terms of the number or width, and embodiments are not limited thereto.

Referring to FIGS. 11C and 12B, a crack detecting line CDL3 may include a plurality of bending portions in an extending direction thereof, and also include a plurality of lines that overlap to be in physical contact with each other. The crack detecting line CDL3 may include a first line L1 having a plurality of bending portions and a second line L2 having a plurality of bending portions, and the first line L1 and the second line L2 may have shapes corresponding to each other. The first line L1 and the second line L2 may overlap each other in a plan view. That is, the crack detecting line CDL3 may be provided in the form in which the first line L1 and the second line L2 are directly stacked on each other. Through the direct contact between the first line L1 and the second line L2, the first line L1 and the second line L2 may be connected to each other, and thus resistance of the crack detecting line CDL3 may be reduced compared to a single-layer structure.

The first line L1 and the second line L2 may be formed through a single patterning process after a plurality of conductive layers are formed in sequence. Accordingly, as illustrated in FIG. 12B, respective side surfaces of the first line L1 and the second line L2 may be aligned with each other. However, this is illustrative, and the first line L1 and the second line L2 may be formed through separate patterning processes, respectively. Here, the first line L1 and the second line L2 may partially overlap each other as illustrated in FIG. 12A, and embodiments are not limited thereto.

According to some embodiments of the present disclosure, the bending portions may be provided on the crack detecting line to relatively improve the sensitivity to the fine crack. In addition, As the crack detecting line CDL3 has the structure in which the plurality of lines are stacked, due to the decreased width, the resistance of the crack detecting line CDL3 itself may be prevented from being excessively increased. The number of the lines constituting each of the crack detecting lines CDL2 and CDL3 is illustrated as two. However, this is illustrative, and three or more lines may be included. According to some embodiments of the present disclosure, the crack detecting circuit with relatively improved electrical reliability and relatively improved sensitivity may be provided.

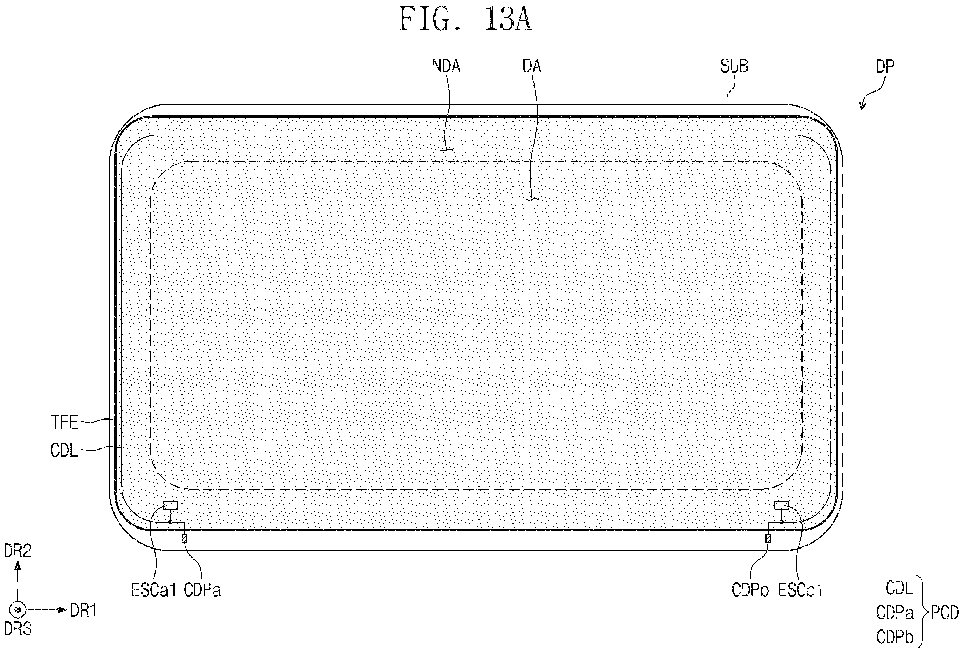

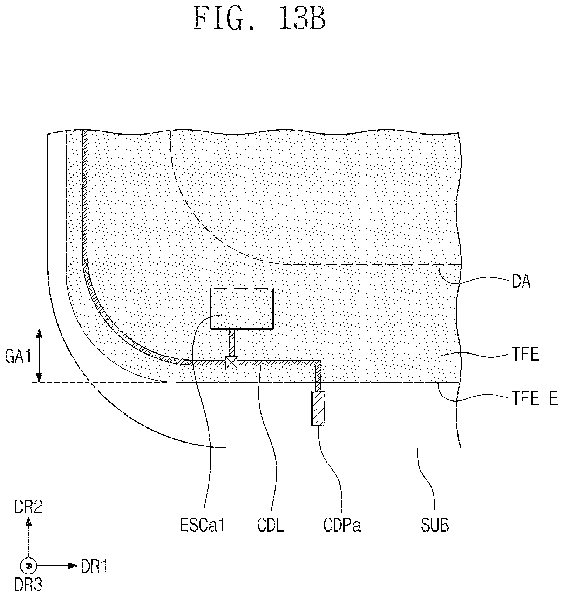

FIG. 13A is a plan view of a display panel according to some embodiments of the present disclosure. FIG. 13B is an enlarged view illustrating a partial area in FIG. 13A. FIG. 13A illustrates an area corresponding to FIG. 7, and FIG. 13B illustrates an area corresponding to FIG. 8. Hereinafter, aspects of some embodiments of the present disclosure will be described in more detail with reference to FIGS. 13A and 13B. The same/similar components as/to those described with reference to FIGS. 1 to 12B are designated by the same/similar reference numbers or symbols, and redundant contents will be omitted.

As illustrated in FIGS. 13A and 13B, each of antistatic circuits ESCa1 and ESCb1 may be located in an area overlapping an encapsulating layer TFE. Each of the antistatic circuits ESCa1 and ESCb1 may be spaced a distance (e.g., a set or predetermined distance) GA1 from an end TFE_E of the encapsulating layer TFE, and be located inside the end TFE_E of the encapsulating layer TFE to overlap the encapsulating layer TFE in a plan view. Each of the antistatic circuits ESCa1 and ESCb1 may disposed between the crack detecting line CDL and the display area DA.

As each of the antistatic circuits ESCa1 and ESCb1 is located at a position spaced apart from the end TFE_E of the encapsulating layer TFE, which is likely to undergo non-deposition or insufficient deposition, a damage to the antistatic circuits ESCa1 and ESCb1 due to the moisture permeation or the like may be prevented or reduced. As each of the antistatic circuits ESCa1 and ESCb1 is located at a position overlapping the encapsulating layer TFE, a surface area of a non-display area NDA may be prevented from being excessively increased.

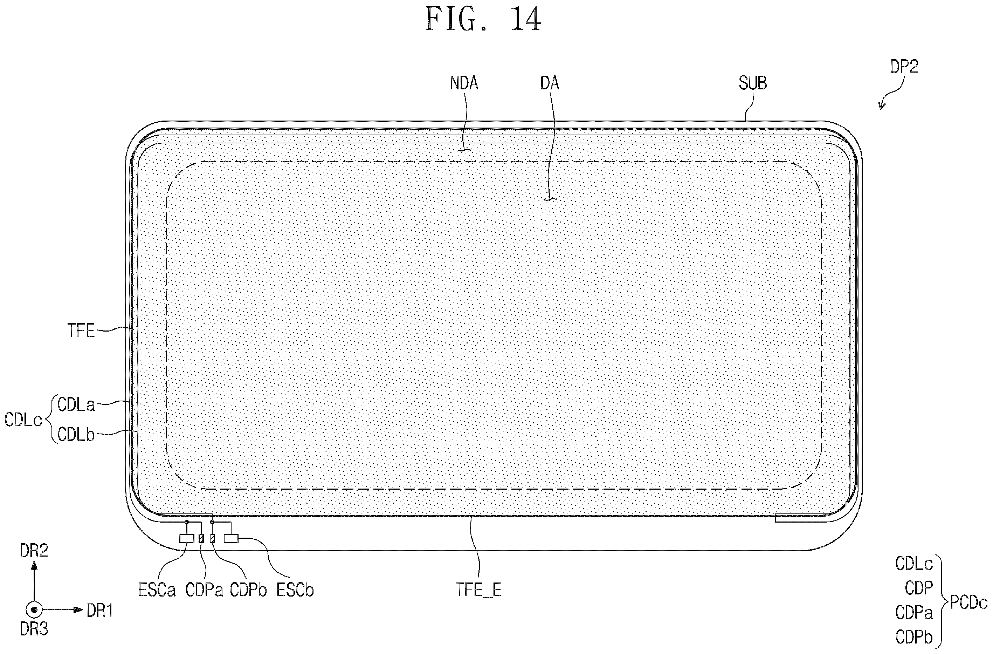

FIG. 14 is a plan view of a display panel according to some embodiments of the present disclosure. FIG. 14 illustrates an area corresponding to FIG. 7. Hereinafter, aspects of some embodiments of the present disclosure will be described in more detail with reference to FIG. 14. The same/similar components as/to those described with reference to FIGS. 1 to 13B are designated by the same/similar reference numbers or symbols, and redundant contents will be omitted.

Referring to FIG. 14, a crack detecting circuit PCDc may be designed so that a first pad CDPa and a second pad CDPb are located adjacent to each other. A crack detecting line CDLc of the crack detecting circuit PCDc may include a first portion CDLa connected to the first pad CDPa to extend to an opposite edge of a display area DA, and a second portion CDLb connected to the first portion CDLa and arranged parallel to the first portion CDLa to be connected to the second pad CDPb. The first portion CDLa and the second portion CDLb may extend to be parallel to each other along sides of the display area DA. That is, the crack detecting line CDLc may have a shape in which two lines of the first portion CDLa and the second portion CDLb extend to be parallel to each other along the display area DA. Thus, the sensitivity to the fine crack may be relatively improved.

Antistatic circuits ESCa and ESCb do not overlap an end of an encapsulating layer TFE, and are located adjacent to the first pad CDPa and the second pad CDPb, respectively, and connected to two ends of the crack detecting line CDLc, respectively. According to some embodiments of the present disclosure, the antistatic circuits ESCa and ESCb may be located at the same side (e.g., the left side) with respect to a center of the display area DA. Accordingly, the design of the antistatic circuits ESCa and ESCb and the crack detecting circuit PCDc may be simplified.

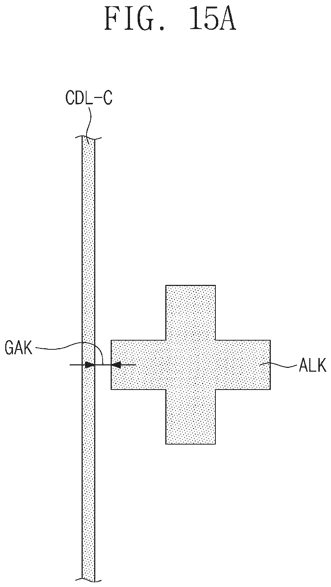

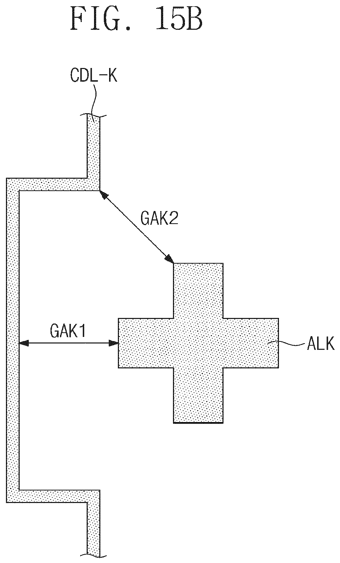

FIG. 15A is a plan view of a crack detecting line according to a Comparative Example. FIG. 15B is a plan view of a crack detecting line according to some embodiments of the present disclosure. FIGS. 15A and 15B illustrate areas corresponding each other. Hereinafter, aspects of some embodiments of the present disclosure will be described in more detail with reference to FIGS. 15A and 15B.

As illustrated in FIG. 15A, a crack detecting line CDL-C according to Comparative Example (hereinafter referred to as Comparative Example) may be located in an area adjacent to an alignment mark ALK. Comparative Example CDL-C may have a line shape that is one straight line. Accordingly, in a case in which a distance GAK with the alignment mark ALK is small, static electricity may be likely to be generated, and thus there is a concern for a damage to the Comparative Example CDL-C.

As illustrated in FIG. 15B, in a crack detecting line CDL-K according to some embodiments of the present disclosure, an area adjacent to an alignment mark ALK may have a bending shape, for example, may be concave with respect to the alignment mark ALK. Through the bending shape, the crack detecting line CDL-K may extend from a position spaced each of sufficient distances GAK1 and GAK2 from the alignment mark ALK, and thus the crack detecting line CDL-K may be designed to avoid a path on which static electricity is likely to be generated between the crack detecting line CDL-K and the alignment mark ALK. Therefore, electrical stability of a crack detecting circuit may be improved.

As discussed, embodiments may provide a display device comprising: a substrate having a display area and a non-display area adjacent to the display area; a plurality of pixels on the substrate, and each of which comprises a transistor and a light emitting element connected to the transistor; an encapsulating layer covering the pixels and having an end defined in the non-display area; a crack detecting circuit in the non-display area along at least a portion of an edge of the display area; and an antistatic circuit in the non-display area and connected to the crack detecting circuit, wherein the antistatic circuit is spaced apart from the end of the encapsulating layer in a plan view.

The non-display area may surround the display area. For example, the display area may be a four sided shape, and the non-display area may be located outside the display area.

The crack detecting circuit may detect a crack, for example by detecting a change is resistance. The crack detecting circuit may comprise a crack detecting line, and may monitor the resistance of the crack detecting line. The crack detecting line may be connected to a sensor, such as a voltage or current sensor.

The antistatic circuit may prevent or reduce damage to the crack detecting circuit caused by static electricity generation or the like. The antistatic circuit may be connected to various lines (e.g. voltage lines and/or signal lines) of the display device. The antistatic circuit may be provided as one or more circuit elements capable of stably discharging the static electricity of the crack detecting line.

Embodiments may provide an electronic device comprising: a display panel; and a window covering the display panel, the display panel being according to any of the above described embodiments.

Embodiments may provide an electronic device comprising: a display panel; and a window covering the display panel, and the display panel comprising: a substrate having a display area and a non-display area adjacent to the display area; a plurality of pixels on the substrate, and each of which comprises a transistor and a light emitting element connected to the transistor; an encapsulating layer covering the pixels and having an end defined in the non-display area; a crack detecting line in the non-display area along at least a portion of an edge of the display area, and comprising a first end and a second end; and an antistatic circuit in the non-display area and connected to the first end or the second end of the crack detecting line, wherein the antistatic circuit does not overlap the end of the encapsulating layer in a plan view.

According to some embodiments of the present disclosure, whether the crack is initiated due to the external impact may be relatively stably measured.

Moreover, according to some embodiments of the present disclosure, damage to the circuit for measuring whether the crack is initiated due to the static electricity or the like may be prevented or reduced.

Although the embodiments of the present invention have been described, it is understood that the present invention should not be limited to these embodiments but various changes and modifications can be made by one ordinary skilled in the art within the scope of the present invention as hereinafter claimed. Rather, these embodiments set forth herein are provided so that this disclosure will be thorough and complete, and will fully convey the scope of the inventive concept to those skilled in the art.

## Claims

1. A display device comprising:
a substrate having a display area and a non-display area adjacent to the display area;
a plurality of pixels on the substrate, and each of which comprises a transistor and a light emitting element connected to the transistor;
an encapsulating layer covering the pixels and having an end defined in the non-display area;
a crack detecting circuit in the non-display area along at least a portion of an edge of the display area; and
an antistatic circuit in the non-display area and connected to the crack detecting circuit,
wherein the antistatic circuit is spaced apart from the end of the encapsulating layer in a plan view.

2. The display device of claim 1, wherein the crack detecting circuit comprises:
a crack detecting line extending along at least three sides of the display area, and comprising a first end and a second end;
a first pad connected to the first end of the crack detecting line; and
a second pad connected to the second end of the crack detecting line,
wherein the antistatic circuit is adjacent to the first pad or the second pad.

3. The display device of claim 2, wherein the antistatic circuit comprises:
a first antistatic circuit connected to a portion, which is adjacent to the first pad, of the crack detecting line; and
a second antistatic circuit connected to a portion, which is adjacent to the second pad, of the crack detecting line.

4. The display device of claim 1, wherein the crack detecting circuit comprises:
a crack detecting line in the non-display area along at least a portion of the edge of the display area, and comprising a first end and a second end;
wherein the antistatic circuit is connected to the first end or the second end of the crack detecting line,

5. The display device of any one of claims 2 to 4, further comprising a data driver in the non-display area and connected to the pixels,
wherein the first end and the second end of the crack detecting line are spaced apart from each other with the data driver therebetween.

6. The display device of any one of claims 2 to 5, further comprising a data driver in the non-display area and connected to the pixels,
wherein the first end and the second end of the crack detecting line are at a same side with respect to the data driver.

7. The display device of any one of claims 2 to 6, wherein the antistatic circuit does not overlap the encapsulating layer in a plan view.

8. The display device of claim 6 when dependent on claim 2, wherein the antistatic circuit overlaps the first pad or the second pad.

9. The display device of any one of claims 2 to 6, wherein the antistatic circuit overlaps the encapsulating layer in a plan view;
optionally wherein the antistatic circuit is between the crack detecting line and the display area.

10. The display device of any one of claims 2 to 9, wherein the crack detecting line comprises at least one bending portion,
wherein the bending portion is concave or convex toward the display area;
optionally further comprising an alignment mark in the non-display area, wherein the bending portion is concave with respect to the alignment mark.

11. The display device of any one of claims 2 to 10, wherein the crack detecting line comprises:
a first line extending in one direction; and
a second line extending in the one direction, on a same layer as the first line, and overlapping the first line in at least a partial area in a plan view,
wherein the first line and the second line contact each other in the at least a partial area;
optionally wherein each of the first line and the second line comprises at least one bending portion, wherein the first line and the second line entirely overlap each other.

12. The display device of any one of claims 1 to 11, wherein the encapsulating layer comprises at least one inorganic film and at least one organic film,
wherein the end of the encapsulating layer is defined by the inorganic film.

13. The display device of claim 12, wherein the encapsulating layer comprises a plurality of inorganic films,
wherein the end of the encapsulating layer is aligned ends of at least two inorganic films.

14. The display device of any one of claims 1 to 13, wherein the encapsulating layer comprises:
a first inorganic film;
a second inorganic film; and
an organic film between the first inorganic film and the second inorganic film,
wherein the end of the encapsulating layer is aligned with ends of the first inorganic film and the second inorganic film;
optionally wherein the antistatic circuit overlaps the first inorganic film and the second inorganic film in a plan view or the antistatic circuit does not overlap the first inorganic film and the second inorganic film in a plan view.

15. An electronic device comprising:
a display panel; and
a window covering the display panel, and
the display panel being according to any one of claims 1 to 14.
